(19) **Europäisches Patentamt**
**European Patent Office**
**Office européen des brevets**

(11) **EP 1 257 051 B1**

(12) **EUROPÄISCHE PATENTSCHRIFT**

(45) Veröffentlichungstag und Bekanntmachung des Hinweises auf die Patenterteilung:
**14.11.2007 Patentblatt 2007/46**

(51) Int Cl.:
***H03D 3/00*** *(2006.01)*

(21) Anmeldenummer: **02100461.9**

(22) Anmeldetag: **08.05.2002**

(54) **FM-Demodulator mit Nachbarkanalunterdrückung**

FM Demodulator using adjacent canal suppression

Démodulateur-FM utilisant la suppression de canaux voisins

(84) Benannte Vertragsstaaten:
**AT BE CH CY DE DK ES FI FR GB GR IE IT LI LU MC NL PT SE TR**

(30) Priorität: **10.05.2001 DE 10122748**

(43) Veröffentlichungstag der Anmeldung:
**13.11.2002 Patentblatt 2002/46**

(73) Patentinhaber: **NXP B.V.**
**5656 AG Eindhoven (NL)**

(72) Erfinder: **Dick, Burkhard**
**c/o Philips Corp. Intell. Prop.Gmbh**
**52066, Aachen (DE)**

(74) Vertreter: **Volmer, Georg et al**
**Philips Intellectual Property & Standards GmbH,**
**Postfach 50 04 42**
**52088 Aachen (DE)**

(56) Entgegenhaltungen:
**US-A- 3 911 366        US-A- 5 307 517**
**US-A- 5 341 107**

**Beschreibung**

Die Erfindung betrifft eine Filtereinrichtung und eine Demodulatorschaltung.

Eine Demodulatorschaltung im Sinne dieser Erfindung arbeitet grundsätzlich ähnlich wie eine Demodulator-schaltung, unterdrückt jedoch das gewünschte Nutzsignal und verbessert das Rausch-Signal-Verhältnis, Die Demodulatorschaltung kann grundsätzlich aufgebaut sein wie eine bekannte Demodulatorschaltung, verwendet jedoch anstelle eines Bandpaßfilters ein Kerbfilter (NOTCH-Filter) als Phasenschieber oder Laufzeitglied.

Die Verwendung von Kerbfiltern, auch in Verbindung mit Demodulatoren, zur Unterdrückung bestimmter Frequenzbereiche ist im Stand der Technik bekannt.

Die US-A-5 307 517 beschreibt ein adaptives Kerbfilter für die Unterdrückung von FM-Störungen in FM-Empfängemtationen. Figur 5 dieser Schrift zeigt eine Schaltungsanordnung mit zwei PLL-Demodulatoren und zwei vorgeschalteten Kerbfiltern, wobei die Kerbfilter in dieser Anordnung nicht zur Phasenschiebung verwendet werden. Der eine Zweig der Demodulatorschaltung dient zur Demodulation eines starken Signals und der andere zur Demodulation eines schwachen Signals. Das Eingangssignal umfasst beide Nutzsignale, d.h. das starke und das schwache Signal, und weitere, kleinere Störsignale. Der Demodulator des ersten Zweigs ist auf das stärkere Signal eingestellt (gelockt) und stellt das Kerbfilter des zweiten Zweiges auf die gleiche Resonanzfrequenz ein Der Demodulator des zweiten Zweiges ist auf das kleinere Signal eingestellt (gelockt) und stellt das Kerbfilter des ersten Zweiges auf die gleiche Resonanzfrequenz ein Somit wird im ersten Zweig das schwache Signal unterdrückt und das starke Signal durchgelassen und im zweiten Zweig umgekehrt. Die Kerbfilter sind nicht Teil des eigentlichen Demodulators, sondern diesem vorgeschaltet. Die Kerbfilter sind ferner nicht auf die jeweiligen Nutzsignale des Zweiges, in dem sie vorgesehen sind, abgestimmt, sondern sie sind so eingestellt, dass sie in dem jeweiligen Zweig das unerwünschte Signal unterdrücken, wie es im Stand der Technik üblich ist.

Die JP 0590040308AA, JP 0060069821AA und JP 0030004630AA beschreiben jeweils die Verwendung von Kerbfilter in Verbindung mit Demodulatoren zur Verbesserung des Signal-Rausch-Verhältnisses.

Die DE-A-3840999 beschreibt eine Schaltungsanordnung zur Unterdrückung schmalbandiger Störsignale in einem Empfänger, wobei ein Abstimmsystem in dem Empfänger ein gewünschtes Frequenzband einstellt. Ein Rechenwerk berechnet die Differenz zwischen der Frequenz, auf welche der Empfänger eingestellt ist, und der Frequenz des größten Störers und regelt abhängig davon einen PLL-Oszilator. Die Frequenz wird so eingestellt, dass der Störer in den Bereich eines Kerbfilters fällt. Das Ausgangssignal des Kerbfilters ist somit von der Störung befreit und bildet ein Eingangssignal des Demodulators.

Weitere Demodulatoren des Standes der Technik, welche Kerbfilter zur Unterdrückung von Störsignalfrequenzen verwenden, sind beispielsweise in der DE-A-19735798 und DE-A-4220228 beschrieben.

In den heute üblichen FM-Radioempfängersystemen werden Zwischenfrequenz(IF)-Filter mit nichtveränderbarer Filtercharakteristik, zB. Keramikfilter, verwendet, die außerhalb der integrierten Schaltungen des Radioempfängers als externe Bauteile realisiert werden müssen, und somit einen erheblicher Kostenfaktor darstellen. Für eine bestimmte Nachbarkanalunterdrückung bei Empfang eines Senders müssen mehrere solche Filter in Reihe geschaltet werden. In den U.S. Patenten 5,220,686 und 5,341,107 der U.S. Philips Corp. sind Funkempfänger für Radios, und insbesondere für Autoradios hoher Qualität, beschrieben, bei denen wenigstens ein Teil der von den IF-Filtern im IF-Pfad realisierten Selektion in einer integrierten Schaltung verwirklicht ist. Solche integrierten Filter können abhängig von den Signalbedingungen der empfangenen FM-Signale in ihrer Bandbreite verändert werden. Insbesondere sollte dann, wenn keine oder nur geringe Störsignale vorhanden sind, die Bandbreite der Filter groß ausgelegt werden, während bei dem Auftreten von Störsignalen die Bandbreite entsprechend verkleinert werden sollte. Bei einer Demodulatorschaltung die in dem U.S. Patent 5,341,107 beschrieben ist, können die integrierten Filter abhängig vom Störer über einen Nachbarkanaldetektor (ACD) gesteuert werden, dessen Eingangssignal das Ausgangssignal des FM-Demodulators (MPX-Signal) ist. Der FM-Demodulator ist auf das IF-Eingangssignal eingestellt und auf das IF-Nutzsignal optimiert. Wenn ein oder mehrere Störsignale auftreten, liefert dieser FM-Demodulator somit an den Nachbarkanaldetektor ein Signal mit einem relativ hohen Nutzsignal-Rausch-Abstand und somit einem relativ schlechten Stör-Nutzabstand. Um die integrierten IF-Filter in Abhängigkeit von dem Störer optimal zu steuern, muss daher in dem Nachbarkanaldetektor das demodulierte Signal durch aufwendige Filterung von dem Nutzsignalanteil befreit werden, um den Stör-Nutzabstand zu verbessern. Dies erfordert einen erheblichen schaltungstechnischen Aufwand.

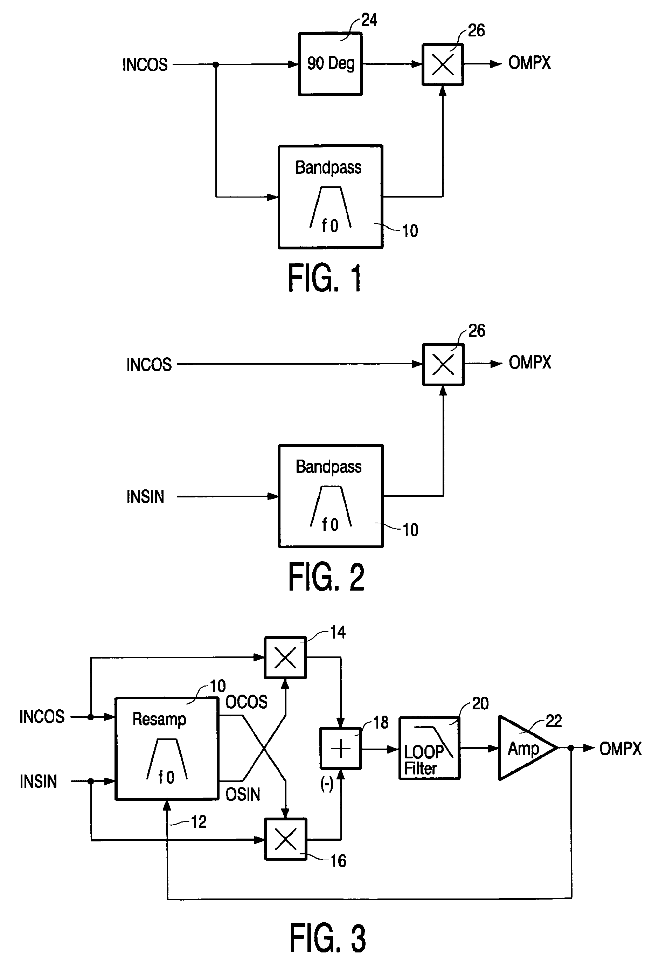

Die Figuren 1 und 2 zeigen den Grundaufbau der aus dem Stand der Technik bekannten FM-Demodulatoren. Die Demudolatoren umfassen als Phasenschieber einen Bandpaß erster Ordnung 10, dessen Phase für die Frequenz des IF-Nutzsignals (f = f0) 0° beträgt. Um das demodulierte Signal OMPX für die Zwischenfrequenz IF(f = f0) zu nomieren, kann in einen Zweig ein konstanter 90°-Phasenschieber eingefügt werden (Figur 1) oder der Demodulator mit 0° (INCOS) und -90° (INSIN)-Signalen angesteuert werden (Figur 2).

Figur 3 zeigt ein Schaltbild eines höher entwickelten Demodulators gemäß dem U.S. Patent 5,341,107, auf das Bezug genommen wird. Auch bei dieser Demodulatorausführung ist der Phasenschieber als ein Bandpaßfilter erster Ordnung oder Resonanzverstärker 10 realisiert, dessen Resonanzfrequenz linear steuerbar ist. Das Bandpaßfilter wird mit 0° (INCOS) und - 90° (INSIN)-Eingangssignalen angesteuert. Die Schaltung weist einen Cosinuspfad und einen Sinuspfad auf, wobei die Übertragungsfunktion für beide Pfade identisch ist und die Phasendifferenz zwischen den beiden Pfaden für alle Frequenzen 90° beträgt. Der Phasengang jedes Pfades entspricht im wesentlichen dem eines Bandpasses erster Ordnung. Der in Figur 3 gezeigte Demodulator bildet einen über einen Resonanzfrequenz-Steuereingang 12 des Bandpasses 10 geschlossenen Loop. Die Mittenfrequenz f0 des Bandpasses 10 wird durch die Rückkopplung des Ausgangssignals OMPX, das dem demodulierten Eingangssignal entspricht, immer auf die Momentanfrequenz der FM-Eingangssignale eingestellt. Bei dieser Frequenz ist die Phasenverschiebung in einem Pfad gleich Null. Somit sind die Eingangssignale der Mischer 14, 16 der beiden Pfade um 90° phasenverschoben, und im stabilen Zustand sind die Ausgangssignale damit quasi Null.

Aufgrund der linearen Abhängigkeit zwischen der Resonanzfrequenz des Resonanzverstärkers 10 und des Steuersignals für die Einstellung des Resonanzverstärkers 10 kann als Steuersignal in dem geschlossenen Loop direkt das demodulierte Ausgangssignal OMPX verwendet werden.

Das demodulierte Ausgangssignal OMPX wird in der in Figur 3 gezeigten Demodulatorschaltung durch Addition bzw. Subtraktion der Ausgangssignale des Cosinuspfades und des Sinuspfades gebildet, wobei einem hierfür vorgesehenen Addiererschaltkreis 18 noch ein Schleifenfilter (LOOP-Filter) 20 und eine Verstärkerschaltung 22 nachgeschaltet sind

Wenn in die Demodulatorschaltung der Figuren 1, 2 oder 3 ein unmoduliertes Nutzsignal mit einer Zwischenfrequenz f=f0 und ein unmodulierter Störer mit einer Frequenz f=f1 eingespeist werden, entspricht die Frequenz des Ausgangssignals dem Betrag von f0-f1. In üblichen Radioempfängeranwendungen kann für einen Störer eines Nachbarkanals beispielsweise eine Frequenz von 100 kHz oder 200 kHz oberhalb oder unterhalb der Frequenz des Nutzsignals angenommen werden. Damit ist die Frequenz des Ausgangssignals OMPX gleich der Differenzfrequenz von 100 kHz bzw. 200 kHz. Die Amplitude des Ausgangsignals ist abhängig von dem Amplitudenabstand der Eingangssignale und vom Frequenzabstand sein. Die Frequenzabhängigkeit ergibt sich aus der Güte der Bandpässe 10, die wiederum die Bandbreite des Demodulators in Fig 1 und 2 bestimmt. Die Demodulatorbandbreite sollte wenigstens so groß sein wie der maximale Frequenzabstand. In Figur 3 kann die Bandbreite des Demodulators über die Grenzfrequenz des Schleifenfilters 20 eingestellt werden. In der Praxis ergibt sich erst bei einem geringen Amplitudenabstand von Störsignal und Nutzsignal ein Gleichstromsignal oder Gleichstromoffset.

In Fig 3 wird die Demodulatorbandbreite durch die Güte des Bandpasses 10 beeinflußt, aber durch die Grenzfrequenz des Loop-Filters 20 hauptsächlich bestimmt.

Wenn die in den Figuren 1 bis 3 gezeigten Demodulatorschaltungen für eine Nachbarkanalerfassung eingesetzt werden, um beispielsweise in einem Radioempfänger eine Filtereinrichtung für eine bestimmte Nachbarkanalunterdrückung abhängig von dem Störer einzustellen, haben diese Schaltungsanordnungen den Nachteil, dass das demodulierte Signal OMPX ein (an sich gewünschtes) schlechtes Stör-Nutzverhältnis aufweist, weil der Bandpaß 10 den Störer im Verhältnis zum Nutzsignal dämpft. Um das Störsignal mitzuerfassen, benötigt der Demodulator eine weit höhere Bandbreite als üblich. Dies führt wiederum zu einer Verringerung der Leistungsfähigkeit für die Demodulation des Nutzsignals. Am Ausgang der in Figur 3 gezeigten Demodulatorschaltung würden sich zB. die Anteile höherer harmonischer Schwingungen der Frequenz f0 erhöhen, die in den Mischerschaltkreisen 14, 16 entstehen. Die Güte des Bandpasses 10 kann bei einer Vergrößerung der Bandbreite nicht mehr optimal auf das Nutzsignal abgestimmt werden. Messungen haben ferner ergeben, dass mit einer Verkleinerung der Bandbreite des Bandpaßfilters 10 das Verhalten in bezug auf Störsignale, welche beim Auftreten von zwei oder mehr Signalen am Antenneneingang in dem weiteren Signalpfad entstehen können (sogenanntes Pfeifstellenverhalten), deutlich verbessert wird.

Speist man in eine Demodulatorschaltung gemäß den Figuren 1, 2 oder 3 ein moduliertes Nutzsignal und ein moduliertes Störsignal ein, sind die in dem demodulierten Signal OMPX enthaltenen Anteile des Nutzsignals (wie an sich gewünscht) sehr groß und müßten mit erheblichem Aufwand gefiltert werden, um dieses Signal für die Nachbarkanalunterdrückung verwenden zu können. Das andererseits relativ schwache Signal, welches durch den Störer bei f0-f1 erzeugt wird, muß mit einem entsprechend großen Schaltungsaufwand aufbereitet werden, um die Filtereinrichtung für die Nachbarkanalunterdrückung einzustellen. Die Frequenzabhängigkeit der Differenzfrequenz zwischen Nutzsignal und Störsignal verschlechtert die Funktion für die Ansteuerung der IF-Filtereinrichtung weiter.

Wie erwähnt, stellt sich erst bei geringem Amplitudenabstand von Störsignal und Nutzsignal ein Gleichstromoffset ein, der jedoch bei einem bestimmten Punkt abrupt auftritt. Dieser kann von einem Offsetdetektor erfaßt, weiter verarbeitet und zur Ansteuerung der Filtereinrichtung additiv verwendet werden. Wenn der Gleichstromoffset jedoch gering ist, muß der Offsetdetektor eine hohe Verstärkung und somit einen entsprechend hohen Schaltungsaufwand aufweisen, wobei zusätzlich ein in der Praxis relativ aufwendiger Abgleich in bezug auf Gleichstromoffset notwendig ist, welche einen anderen Ursprung haben, also Gleichstromoffset, die am Demodulatorausgang auftreten und nicht durch den Störer verursacht sind. Das bei einem bestimmten, kleinen Amplitudenabstand abrupte Auftreten des Gleichstromoffsets macht ferner ein sehr schnell reagierendes System notwendig, das in der Praxis in bezug auf die Stabilität und Störfestigkeit empfindlich gegenüber Streuung der integrierten Bauelemente ist.

Der Erfindung liegt daher die Aufgabe zugrunde, eine Demodulatorschaltung für FM-Radioempfänger-Einrichtungen hoher Qualität anzugeben, die eine effektive und einfache Nachbarkanalunterdrückung möglich macht und einen minimalen Schaltungsaufwand erfordert.

Diese Aufgabe wird durch eine Schaltung mit den Merkmalen von Anspruch 1 sowie eine Filtereinrichtung gemäß Anspruch 8 und eine Demodulatorschaltung gemäß Anspruch 9 gelöst.

Die erfindungsgemäße Schaltung, ist grundsätzlich wie eine Demodulatorschaltung aufgebaut, weist jedoch anstelle des Bandpaßfilters ein Kerbfilter auf, das ein Eingangssignal empfängt, welches ein Nutzsignal und ein Störsignal umfaßt, und ein gefiltertes Signal erzeugt, wobei das Kerbfilter eine Mittenfrequenz hat, die ungefähr der Frequenz des Eingangssignals entspricht, um wenigstens einen Teil des Nutzsignals zu unterdrücken. Die Demodulatorschaltung umfaßt ferner einen Mischerschaltkreis, der das gefilterte Signal und ein phasenverschobenes Eingangssignal empfängt und ein demoduliertes Ausgangssignal ausgibt, das dem Störsignal weitgehend entspricht.

Das Grundkonzept dieser Erfindung basiert somit auf einer Demodulatorschaltung, die ein Kerbfilter oder Notchfilter anstelle des in den Demodulatoren des Standes der Technik üblichen Bandpaßfilters aufweist und das gewünschte Signal (Nutzsignal) unterdrückt und das Rausch-Signal-Verhältnis verbessert.

Bei einer bevorzugten Ausgangsführungsform wird ein Phasenschiebernetzwerk in Reihe mit dem Kerbfilter geschaltet, um einen Gleichstromversatz mit einem hohen Signal-Rausch-Verhältnis zu erhalten.

Bei einer besonders einfachen Ausführungsform kann das Kerbfilter durch Subtraktion des Ausgangssignals eines Bandpaßfilters von dessen Eingangssignal realisiert werden. Dies ist besonders günstig, wenn ein üblicher Demodulator und ein Demodulator gemäß der Erfindung in Kombination verwendet werden, um ein demoduliertes Störsignal für die Nachbarkanalunterdrückung sowie ein demoduliertes Nutzsignal für den Radioempfänger zu erhalten, wobei das Bandpaßfilter in beiden Demodulatoren gemeinsam genutzt werden kann, wodurch redundante Bauteile vermieden werden.

Dem Kerbfilter ist bei einer weiteren bevorzugten Ausführungsform der Erfindung eine Pulsformungsstufe nachgeschaltet, um höhere harmonische Schwingungen bis zu einem gewissen Grad zu unterdrücken.

Weitere bevorzugte Ausführungsformen der Erfindung sind in den abhängigen Ansprüchen angegeben.

Die Erfindung sieht auch eine Filtereinrichtung zur Unterdrückung von Störsignalen und insbesondere von Nachbarkanalstörungen vor, die eine Demodulatorschaltung der oben beschriebenen Art aufweist, wobei die Bandbreite der Filtereinrichtung abhängig von dem Ausgangssignal der Demodulatorschaltung gesteuert wird.

Schließlich sieht die Erfindung auch eine Demodulatorschaltung mit einer Bandpaßfilterschaltung und einer Demodulatorschaltung der oben beschriebenen Art in Kombination und insbesondere in Parallelschaltung vor.

Die erfindungsgemäße Demodulatorschaltung kann beispielsweise in integrierten Schaltung für FM-Radioempfänger eingesetzt werden, welche vollständig integrierte IF-Filtereinrichtung mit abstimmbarer Bandbreite haben. Die Bandbreite kann abhängig von der Größe der Störung in dem Signalfeld kontinuierlich abgestimmt werden, ausgehend von einem breiten Band, wenn keine Störung vorhanden ist, bis zu einem sehr schmalen Band für große Störungen. Das Steuersignal zur Steuerung der Bandbreite wird von dem Ausgang des erfindungsgemäßen Demodulators parallel über einen Nachbarkanaldetektor (ACD) und einen Offsetdetektor erfaßt. Da der Demodulator auf das Störsignal optimiert werden kann, wird das Rausch-Signal-Verhältnis oder der Stör-Nutzabstand hoch.

Mit der erfindungsgemäßen Demodulatorschaltung erübrigt sich ein großer Teil des Schaltungsaufwands und somit wertvoller Chipfläche für die Filterung und Verstärkung des Ausgangssignals des Demodulators für die Nachbarkanalunterdrückung, weil mit dem Demodulator das Störsignal bereits optimal erfaßt werden kann. Das System ist weniger anfällig gegen Streuung der internen Komponenten, die Stabilität und die Zuverlässigkeit sind gegenüber dem Stand der Technik deutlich erhöht.

Die Erfindung ist im Folgenden anhand bevorzugter Ausführungsformen mit Bezug auf die Zeichnungen näher erläutert. In den Figuren zeigen:

Figur 1 einen Schaltplan eines Grundprinzips eines Demodulators gemäß dem Stand der Technik;

Figur 2 einen Schaltplan des Grundprinzips eines abgewandelten Demodulators nach dem Stand der Technik;

Figur 3 einen Schaltplan eines Demodulators, der Gegenstand einer früheren Patentanmeldung demselben Anmelderin ist;

Figur 4 einen Schaltplan des Grundprinzips des erfindungsgemäßen Demodulators;

Figur 5 einen Schaltplan des Grundprinzips einer Abwandlung des erfindungsgemäßen Demodulators;

Figur 6 einen Schaltplan einer bevorzugten Ausführungsform des erfindungsgemäßen Demodulators;

Figur 7 einen Schaltplan einer bevorzugten Realisierungsform des Kerbfilters, das in dem erfindungsgemäßen Demodulator eingesetzt wird;

Figur 8    einen Schaltplan des Grundprinzips des erfindungsgemäßen Demodulators in Verbindung mit einem Demodulator nach dem Stand der Technik;

Figur 9    einen Schaltplan einer bevorzugten Ausführungsform des erfindungsgemäßen Demodulators in Verbindung mit der Demodulatorschaltung der Figur 3.

Die Figuren 1 bis 3 zeigen Schaltbilder von Demodulatorschaltungen, die Bandpaßfilterverwendung, gemäß dem Stand der Technik, wobei Figur 3 auf einer früheren Patentanmeldung derselben Anmelderin beruht.

In Figur 1 ist eine Bandpaßfilterschaltung erster Ordnung mit 10 bezeichnet, eine 90°-Phasenschieberschaltung ist mit 24 bezeichnet, und ein Mischerschaltkreis ist mit 26 bezeichnet. Entsprechende Bauteile sind in Figur 2 mit denselben Bezugszeichen bezeichnet.

Die Funktionen der Schaltungen der Figuren 1 und 2 korrespondieren einander und wurden oben bei der Erörterung des Standes der Technik bereits beschrieben.

Die Schaltung der Figur 3 entspricht dem U.S. Patent 5,341,107, wobei auf die Beschreibung der Funktionsweise dieser Schaltung Bezug genommen wird. Sie wurde ebenfalls bei der Erörterung des Standes der Technik bereits beschrieben.

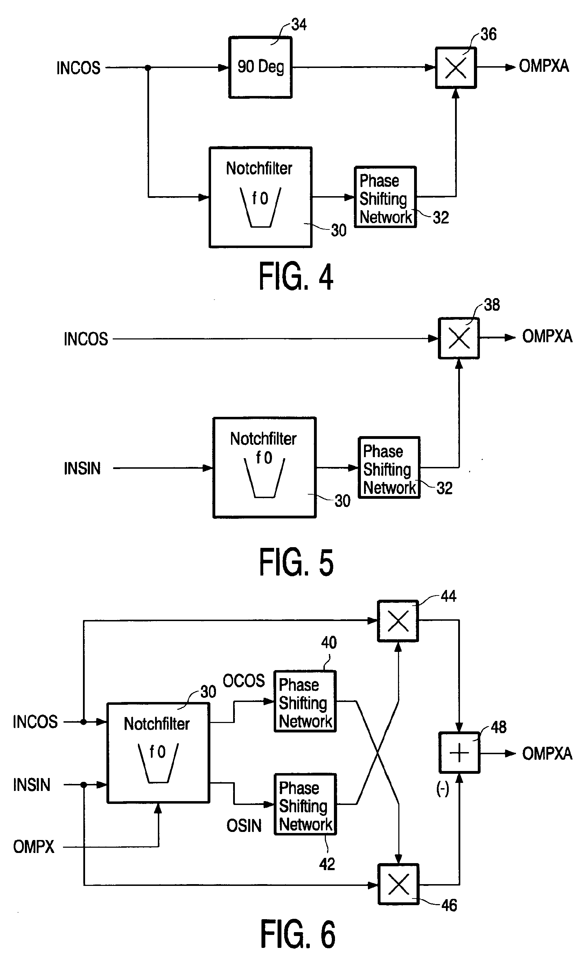

Die Figuren 4 bis 6 zeigen eine erste, eine zweite und eine dritte Ausführungsform des erfindungsgemäßen Demodulators, wobei die Schaltkreise den Demodulatorschaltungen der Figuren 1 bis 3 entsprechen, die Bandpaßfilterschaltung 10 jedoch durch einen Kerbfilterschaltkreis, oder NOTCH-Filter 30 ersetzt wurde.

Die Demodulatorschaltung der Figur 4 umfaßt neben dem Kerbfilterschaltkreis 30 ein Phasenschieber-Netzwerk 32, einen festen 90°-Phasenschieber 34 und einen Mischerschaltkreis 36, die auf die in Figur 4 gezeigte Weise miteinander verbunden sind. Die Demodulatorschaltung der Figur 4 empfängt als Eingangssignal ein 0°-Signal mit einem Störsignalanteil und einem Nutzsignalanteil und erzeugt an seinem Ausgang ein demoduliertes Störsignal OMPXA mit einem hohen Stör-Nutzverhältnis, weil das Kerbfilter 30 einen großen Teil des Nutzsignals unterdrücken kann.

Die alternative Schaltungsstruktur der Figur 5 umfaßt neben dem Kerbfilterschaltkreis 30 ein Phasenschiebernetzwerk 32 und einen Mischerschaltkreis 38, die auf die in Figur 5 gezeigte Weise miteinander sind

Die Demodulatorschaltung der Figur 5 arbeitet grundsätzlich so wie die Schaltung der Figur 4, wobei die Demodulatorschaltung als Eingangssignale ein 0°-Signal und ein 90°-Signal empfängt, so dass der 90°-Phasenschieber der Schaltung der Figur 4 weggelassen werden kann. Selbstverständlich können das 0°-Signal und das 90°-Signal auch ausgetauscht werden.

Durch das dem Kerbfilterschaltkreis 30 nachgeschaltete Phasenschiebemetzwerk 32 kann der Gleichstrom-Offset am Ausgang (OMPXA) der Anti-Demodulatorschaltung für f = f0 (d.h. für den Fall, dass nur ein Nutzsignal, jedoch kein Störsignal vorhanden ist) beeinflußt werden. Simulationen haben gezeigt, dass sich bei Auftreten eines Störsignals mit einem solchen Phasenschiebernetzwerk der Gleichstrom-Offset auch schon bei großem Amplitudenabstand von Störsignal und Nutzsignal (dh Störer << Nutzsignal) drastisch vergrößert. Der Gleichstrom-Offset versetzt tritt in diesem Fall nicht mehr abrupt, sondern kontinuierlich auf, so dass das System insgesamt unempfindlicher gegenüber Streuungen wird. Zusätzlich wird auch die Amplitude des resultierenden Wechselsignals mit der Frequenz f0-f1 deutlich größer und unabhängig von f0-f1. (Wie oben erläutert, ist bei einem Demodulator nach dem Stand der Technik die Frequenz des Ausgangssignals abhängig von dem Betrag von f0-f1, wobei f0 die Frequenz des unmodulierten Nutzsignals und f1 die Frequenz des unmodulierten Störers ist.) Dadurch kann der Schaltungsaufwand im Nachbarkanaldetektor, der das Ausgangssignal OMPXA des Demodulators als Steuersignal verwendet, und im Offsetdetektor erheblich reduziert werden, wobei insbesondere im Nachbarkanaldetektor einfachere Filter und eine geringere Verstärkung eingesetzt werden können und im Offsetdetektor eine geringere Verstärkung sowie kein Offsetabgleich notwendig sind

Figur 6 zeigt eine weitere Ausführungsform des erfindungsgemäßen Anti-Demodulators mit einem Kerbfilterschaltkreis 30, zwei Phasenschiebernetzwerken 40, 42, zwei Mischerschaltkreisen 44, 46 und einer Addiererstufe 48, die auf die in Figur 6 gezeigte Weise miteinander verbunden sind. Der Demodulator der Figur 6 umfaßt, entsprechend dem Demodulator der Figur 3 einen Cosinuszweig und einen Sinuszweig, wobei bei der Ausführungsform der Figur 6 das Nutzsignal praktisch vollständig unterdrückt werden kann, weil die Mittenfrequenz des Kerbfilterschaltkreises 30 über einen Steuereingang 50 mit Hilfe des demodulierten Nutzsignals OMPX immer auf die Momentanfrequenz des Eingangssignals eingestellt werden kann.

Der Demodulator der Figur 6 arbeitet ähnlich wie die Demodulatorschaltung der Figur 3, wobei das Ausgangssignal OMPXA dem demodulierten Störsignal entspricht, das praktisch keinen Anteil des Nutzsignals mehr erhält. Wenn eine solche Anti-Demodulatorschaltung in einem FM-Radioempfänger zur Nachbarkanalerfassung verwendet wird, kann die Bandbreite des Demodulators des Radioempfängers optimal auf das Nutzsignal abgestimmt werden.

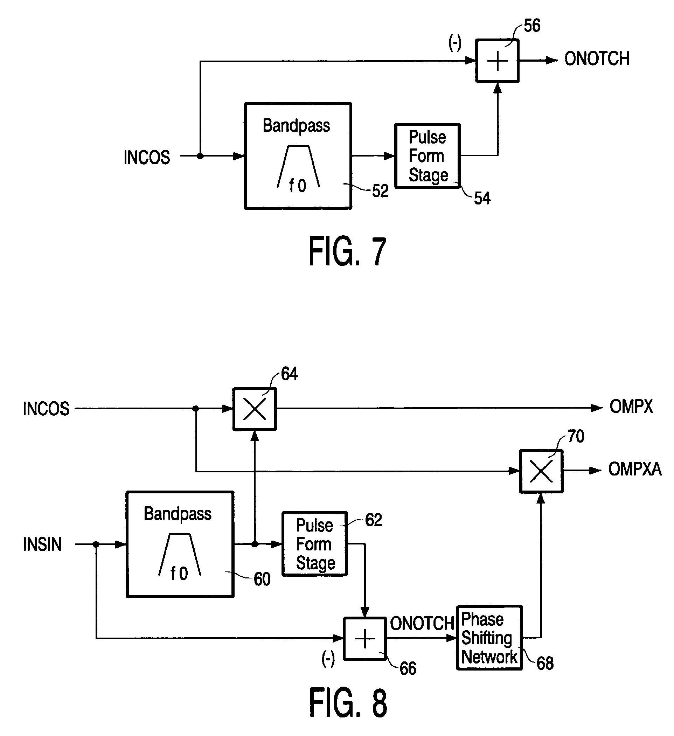

Figur 7 zeigt einen Schaltkreis zur Realisierung der Kerbfilterschaltung des erfindungsgemäßen Demodulators mit Hilfe eines Bandpaßfilters, was den besonderen Vorteil hat, dass das Kerbfilter unter Verwendung des Demodulatorbandpasses, der beispielsweise in einem FM-Radioempfänger regelmäßig vorhanden ist, realisiert werden kann. Dadurch verringert sich der Schaltungsaufwand für den erfindungsgemäßen Anti-Demodulator erheblich Unter der Annahme, dass der Demodulator ein Bandpaßfilter erster Ordnung aufweist, kann die Kerbfilterschaltung gemäß der Formel 1- A(BP) = A(NOTCH) realisiert werden, wobei A(BP) die Übertragungsfunktion des Bandpaßfilters und A(NOTCH) die Übertragungsfunktion des Kerbfilters gemäß den folgenden Formeln darstellt.

$$A(BP) = \frac{a^*jw}{1 + a^*jw + b^*(jw)^2} \quad , \qquad w_0 = b^{-1/2}$$

$$A(NOTCH) = \frac{1 + b^*(jw)^2}{1 + a^*jw + b^*(jw)^2} \quad , \qquad w_0 = b^{-1/2}$$

Die Kerbfilterschaltung der Figur 7, die den Demodulator-Bandpaß einbezieht, umfaßt ein Bandpaßfilter 52, eine Pulsformungsstufe 54 sowie eine Addiererstufe 56, die auf die in Figur 7 gezeigte Weise miteinander verbunden sind. Das Eingangssignal des Kerbfilters ist ein 0°-Eingangssignal INCOS, und das Ausgangssignal ist als Kerbfilter-Ausgangssignal ONOTCH bezeichnet.

Häufig ist das Eingangssignal INCOS oder INSIN der Kerbfilterschaltung ein Rechtecksignal, insbesondere ein Ausgangssignal eines vorgeschalteten Begrenzers. Durch eine mit dem Bandpaßfilter 52 in Reihe geschaltete Pulsformungsstufe 54 kann die Unterdrückung des Nutzsignals, z.B. bezüglich höherer harmonischer Schwingungen, optimiert werden. Im einfachsten Fall ist die Pulsformungsstufe 54 als ein nicht gegengekoppelter Differenzverstärker realisiert.

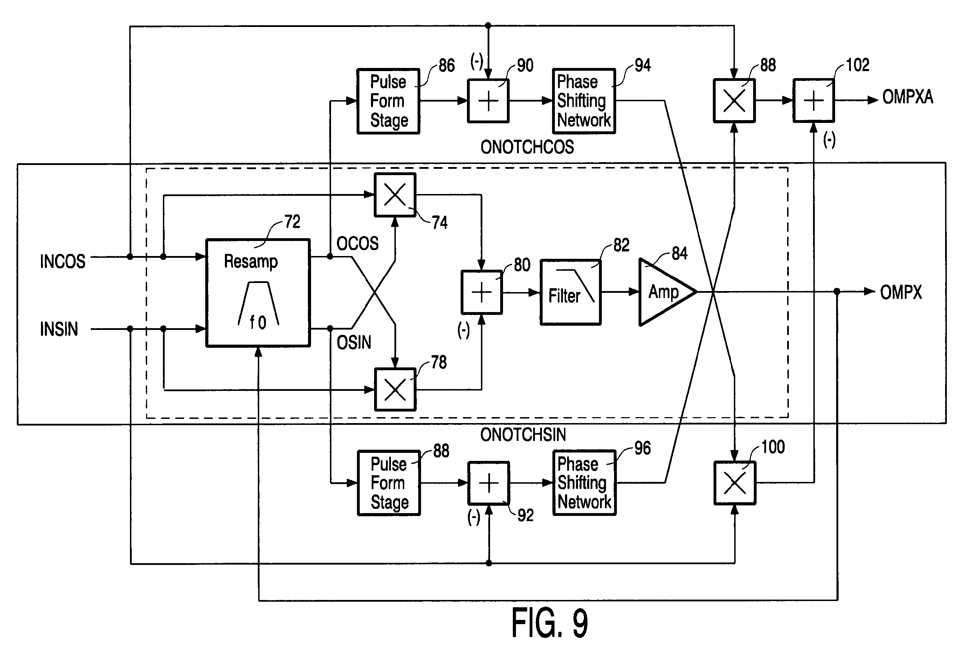

Die Figuren 8 und 9 zeigen zwei bevorzugte Ausführungsformen des erfindungsgemäßen Demodulators in Kombination mit einem herkömmlichen Demodulator, die mit minimalem Schaltungsaufwand realisiert sind Die Ausführungsform der Figur 8 entspricht der Darstellung der Figur 2, und die Ausführungsform der Figur 9 entspricht der Darstellung der Figur 3, wobei in Figur 9 der Demodulatorteil durch ein gestricheltes Rechteck eingegrenzt ist.

Die Anti-Demodulator/Demodulatorschaltung der Figur 8 umfaßt einen Bandpaßfilterschaltkreis 60, eine Pulsformungsstufe 62, einen Mischerschaltkreis 64, eine Addiererstufe 66, ein Phasenschiebernetzwerk 68 und einen weiteren Mischerschaltkreis 70, die auf die in Figur 8 gezeigte Weise verbunden sind. Der /Demodulatorschaltkreis vereinigt in sich die Demodulatorfunktion der Figur 2 und die Anti-Demodulatorfunktion der Figur 5, wobei der Kerbfilterschaltkreis 30 der Figur 5 durch den in Figur 7 dargestellten Schaltkreis ersetzt ist.

Figur 9 zeigt eine bevorzugte Ausführungsform einer Demodulatorschaltung gemäß der Erfindung. Diese umfaßt einen Bandpaßfilterschaltkreis 72, zwei Mischerschaltkreise 74 und 78, eine Addiererstufe 80, eine Loopfilterschaltung 82, eine Verstärkerstufe 84, zwei Pulsformungsstufen 86, 88, zwei weitere Addiererstufen 90, 92, zwei Phasenschiebernetzwerke 94, 96, zwei weitere Mischerschaltkreise 98,100 und eine weitere Addiererstufe 102, die auf die in Figur 9 gezeigte Weise miteinander verbunden sind. Die Demodulatorschaltung der Figur 9 umfaßt einen Demodulator, welcher der Ausführungsform der Figur 3 entspricht und durch das gestrichelte Kästchen kenntlich gemacht ist. Sie umfaßt ferner einen Demodulator mit einem Cosinuszweig und einem Sinuszweig, der der Ausführungsform der Figur 6 entspricht, wobei der Kerbfilterschaltkreis 30 der Figur 6 durch den Schaltkreis der Figur 7 ersetzt ist. Der Vorteil der in Figur 9 gezeigten /Demodulator-schaltung gegenüber den vorher beschriebenen Varianten ist wiederum, dass die Mittenfrequenz der Kerbfilterschaltung des Demodulators und somit des Bandpaßschaltkreises 72 des Demodulators der Momentanfrequenz der Eingangssignale folgt.

Die in der vorstehenden Beschreibung den Ansprüchen und der Zeichnung offenbarten Merkmale können sowohl einzeln als auch in beliebiger Kombination für die Erfindung in ihren verschiedenen Ausgestaltungen von Bedeutung sein.

BEZUGSZEICHENLISTE

Bandpaß                                    10

| | |
|---|---|
| Resonanzfrequenz-Steuereingang | 12 |
| Mischer | 14, 16 |
| Addiererschaltkreis | 18 |
| Loop-Filter | 20 |
| Verstärkerschaltung | 22 |
| Phasenschieberschaltung | 24 |
| Mischerschaltkreis | 26 |
| Kerbfilterschaltkreis | 30 |
| Phasenschiebernetzwerk | 32, 34 |
| Mischerschaltkreis | 36, 38 |
| Phasenschiebernetzwerk | 40, 42 |
| Mischerschaltkreis | 44, 46 |
| Addiererstufe | 48 |
| Steuereingang | 50 |
| Bandpaßfilter | 52 |
| Pulsformungsstufe | 54 |
| Addiererstufe | 56 |
| Bandpaßfilterschaltkreis | 60 |
| Pulsformungsstufe | 62 |
| Mischerschaltkreis | 64 |
| Addiererstufe | 66 |
| Phasenschiebernetzwerk | 68 |
| Mischerschaltkreis | 70 |
| Bandpaßfilterschaltkreis | 72 |
| Mischerschaltkreis | 74, 78 |
| Addiererstufe | 80 |
| Loopfilterschaltung | 82 |
| Verstärkerstufe | 84 |
| Pulsformungsstufe | 86, 88 |
| Addiererstufe | 90,92 |
| Phasenschiebernetzwerk | 94, 96 |
| Mischerschaltkreis | 98, 100 |
| Addiererstufe | 102 |

**Patentansprüche**

1. Schaltung zum Unterdrücken eines Nutzsignals eines ein Nutzsignal und ein Störsignal umfassenden Signals mit einem Kerbfilter (30), das ein Eingangssignal (INCOS) empfängt, welches das Nutzsignal und das Störsignal umfaßt, und ein gefiltertes Signal erzeugt, wobei das Kerbfilter (30) eine Mittenfrequenz aufweist, die ungefähr der Frequenz des Nutzsignals entspricht, um wenigstens einen Teil des Nutzsignals zu unterdrücken, und einem Mischerschaltkreis (36; 38), der das gefilterte Signal empfängt und ein demoduliertes Ausgangssignal (OMPXA) ausgibt, das dem Störsignal weitgehend entspricht, **dadurch gekennzeichnet,** **daß** der Mischerschaltkreis außerdem ein phasenverschobenes Eingangssignal (INSIN) empfängt und **daß** ein Phasenschiebernetzwerk (32) in Reihe mit dem Kerbfilter (30) geschaltet ist.

2. Schaltung nach Anspruch 1, **gekennzeichnet durch** einen dem Mischerschaltkreis (36; 38) vorgeschalteten 90°-Phasenschieber zur Erzeugung eines um 90° phasenverschobenen Eingangssignals (INSIN) für den Mischerschaltkreis (36; 38).

3. Schaltung nach einem der vorangehenden Ansprüche, **dadurch gekennzeichnet, daß** das Kerbfilter (30) das Eingangssignal (INCOS) und ein um 90° phasenverschobenes Eingangssignal (INSIN) empfängt und zwei um 90° phasenverschobene Kerbfilter-Ausgangssignale (OCOS, OSIN) erzeugt, dem Kerbfilter (30) ein Phasenschiebernetzwerk (40, 42) nachgeschaltet ist, welches die Kerbfilter-Ausgangssignale (OCOS, OSIN) empfängt, und durch zwei Demodulatorzweige, die jeweils einen Mischerschaltkreis (44, 46) aufweisen, wobei ein erster Eingang eines ersten Mischerschaltkreises (44) das Eingangssignal empfängt und ein zweiter Eingang des ersten Mischerschaltkreises (44) ein Ausgangssignal des Phasenschiebernetzwerkes empfängt, das auf dem um 90° phasenverschobenen Eingangssignal beruht, ein erster Eingang des zweiten Mischerschaltkreises (46) das um 90° phasenverschobene Eingangssignal empfängt und ein zweiter Eingang des zweiten Mischerschaltkreises (46) ein Ausgangssignal des Phasenschiebernetzwerkes empfängt, das auf dem nicht-phasenverschobenen Eingangssignal beruht, und wobei

die Ausgangssignale der Mischerschaltungen (44, 46) in einer Addiererschaltung (48) kombiniert werden, um ein demoduliertes Störsignal (OMPXA) zu erzeugen.

4. Schaltung nach Anspruch 3, **dadurch gekennzeichnet, daß** die Mittenfrequenz des Kerbfilters (30) abhängig von dem Nutzsignal steuerbar ist.

5. Schaltung nach einem der vorangehenden Ansprüche, **dadurch gekennzeichnet, daß** das Kerbfilter mithilfe eines Bandpaßfilters (52) gemäß der Formel "1 - A(BP) = A(Notch)" realisiert ist, wobei A(BP) die Übertragungsfunktion des Bandpaßfilters (52) und A(Notch) die Übertragungsfunktion des Kerbfilters ist.

6. Schaltung nach Anspruch 5, **dadurch gekennzeichnet, daß** das Kerbfilter eine Bandpaßfilterschaltung (52; 60) und einen Addiererschaltkreis (56; 66) aufweist, die Bandpaßfilterschaltung (52; 60) das Eingangssignal empfängt und ein bandpaßgefiltertes Eingangssignal erzeugt und der Addiererschaltkreis (56; 66) ein Kerbfilter-Ausgangssignal (ONOTCH) als eine Differenz des bandpaßgefilterten Eingangssignals und des Eingangssignals erzeugt.

7. Schaltung nach einem der vorgenannten Ansprüche, **dadurch gekennzeichnet, daß** eine Pulsformungsstufe (54; 62) mit dem Kerbfilter in Reihe geschaltet ist.

8. Filtereinrichtung zur Unterdrückung von Störsignalen, **gekennzeichnet durch** eine Schaltung zum Unterdrücken eines Nutzsignals eines ein Nutzsignal und ein Störsignal umfassenden Signals nach einem der vorangehenden Ansprüche, wobei die Bandbreite der Filtereinrichtung abhängig von dem Ausgangssignal (OMPXA) der Schaltung zum Unterdrücken des Nutzsignals des das Nutzsignal und das Störsignal umfassenden Signals steuerbar ist.

9. Demodulatorschaltung mit einer Bandpaßfilterschaltung und einer Schaltung zum Unterdrücken eines Nutzsignals eines ein Nutzsignal und ein Störsignal umfassenden Signals nach einem der vorangehenden Ansprüche 1 - 6, die zu der Bandpaßfilterschaltung parallel geschaltet ist.

10. Demodulatorschaltung nach Anspruch 9, **dadurch gekennzeichnet, daß** die Mittenfrequenz der Bandpaßfilterschaltung abhängig von dem demodulierten Nutzsignal (OMPX) steuerbar ist.

11. Demodulatorschaltung nach Anspruch 9 oder 10, umfassend:

ein Bandpaßfilter (60), einen ersten und einen zweiten Mischerschaltkreis (64, 70) und einen Addiererschaltkreis (66), wobei das Bandpaßfilter (60) das Eingangssignal empfängt und ein bandpaßgefiltertes Eingangssignal erzeugt und der Addiererschaltkreis (66) ein Kerbfilter-Ausgangssignal (ONOTCH) als eine Differenz des bandpaßgefilterten Eingangssignals und des Eingangssignals erzeugt, der erste Mischerschaltkreis (64) das bandpaßgefilterte Eingangssignal und ein um 90° phasenverschobenes Eingangssignal kombiniert, um ein demoduliertes Nutzsignal (OMPX) zu erzeugen, und der zweite Mischerschaltkreis (70) das Kerbfilter-Ausgangssignal (ONOTCH) und ein um 90° phasenverschobenes Eingangssignal kombiniert, um ein demoduliertes Störsignal (OMPXA) zu erzeugen.

12. Demodulatorschaltung nach Anspruch 11, **dadurch gekennzeichnet, daß** das Bandpaßfilter (72) das Eingangssignal und das um 90° phasenverschobene Eingangssignal empfängt und dem Bandpaßfilter (72) zwei parallele Schaltungszweige zum Unterdrücken des Nutzsignals nachgeschaltet sind, welche jeweils einen Addiererschaltkreis (90, 92) aufweisen, um ein erstes und ein zweites, um 90° phasenverschobenes Kerbfilter-Ausgangssignal (ONOTCH COS, ONOTCH SIN) zu erzeugen, sowie zwei parallele Demodulatorzweige, welche jeweils einen Mischerschaltkreis (74, 78) aufweisen, um ein erstes und ein zweites, um 90° phasenverschobenes demoduliertes Nutzsignal zu erzeugen.

13. Demodulatorschaltung nach Anspruch 12, **dadurch gekennzeichnet, daß** die zwei Demodulatorzweige in einem Addiererschaltkreis (80) zusammengeführt sind, um eine Differenz aus dem demodulierten Nutzsignal und dem phasenverschobenen demodulierten Nutzsignal zu erzeugen, wobei dem Addiererschaltkreis (80) ein Verstärkerschaltkreis (84) nachgeschaltet ist.

**14.** Demodulatorschaltung nach Anspruch 12 oder 13, **dadurch gekennzeichnet, daß** die Ausgänge der zwei Schaltungszweige zum Unterdrücken des Nutzsignals auf einen Addiererschaltkreis (102) geführt sind, um eine Differenz zwischen dem demodulierten Störsignal und dem phasenverschobenen demodulierten Störsignal zu bilden.

**Claims**

**1.** A circuit comprising for suppressing a useful signal of a signal comprising a useful signal and an interference signal, the circuit comprising:

a notch filter (30) which receives an input signal (INCOS) comprising the useful signal and the interference signal, and generates a filtered signal, wherein the notch filter (30) has a center frequency which corresponds approximately to the frequency of the useful signal to suppress at least part of the useful signal, and
a mixer circuit (36; 38) which receives the filtered signal and outputs a demodulated output signal (OMPXA) which substantially corresponds to the interference signal,

**characterized**
**in that** the mixer circuit further receives a phase-shifted input signal (INSIN) and
**in that** a phase shifter network (32) is connected in series to the notch filter (30).

**2.** A circuit as claimed in claim 1, **characterized by** a 90° phase shifter preceding the mixer circuit (36; 38) for generating a 90° phase-shifted input signal (INSIN) for the mixer circuit (36; 38).

**3.** A circuit as claimed in any one of the preceding claims, **characterized in that** the notch filter (30) receives the input signal (INCOS) and a 90° phase-shifted input signal (INSIN), and generates two 90° phase-shifted notch filter output signals (OCOS, OSIN), the notch filter (30) precedes a phase-shifting network (40, 42) which receives the notch filter output signals (OCOS, OSIN) and is constituted by two demodulator branches each comprising a mixer circuit (44, 46), a first input of a first mixer circuit (44) receiving the input signal and a second input of the first mixer circuit (44) receiving an output signal of the phase-shifting network which is based on the 90° phase-shifted input signal, a first input of the second mixer circuit (46) receiving the 90° phase-shifted input signal and a second input of the second mixer circuit (46) receiving an output signal of the phase-shifting network which is based on the non-phase-shifted input signal, and the output signals of the mixer circuits (44, 46) being combined in an adder circuit (48) so as to generate a demodulated interference signal (OMPXA).

**4.** A circuit as claimed in claim 3, **characterized in that** the center frequency of the notch filter (30) is controllable in dependence on the useful signal.

**5.** A circuit as claimed in any one of the preceding claims, **characterized in that** the notch filter is realized by means of a bandpass filter (52) in accordance with the formula "1 - A(BP) = A(Notch)", wherein A(BP) is the transfer function of the bandpass filter (52) and A(Notch) is the transfer function of the notch filter.

**6.** A circuit as claimed in claim 5, **characterized in that** the notch filter comprises a bandpass filter circuit (52; 60) and an adder circuit (56; 66), the bandpass filter circuit (52; 60) receives the input signal and generates a bandpass-filtered input signal, and the adder circuit (56; 66) generates a notch filter output signal (ONOTCH) as a difference between the bandpass-filtered input signal and the input signal.

**7.** A circuit as claimed in any one of the preceding claims, **characterized in that** a pulse-forming stage (54; 62) is arranged in series with the notch filter.

**8.** A filter device for suppressing interference signals, **characterized by** a circuit for suppressing a useful signal of a signal comprising a useful signal and an interference signal as claimed in any one of the preceding claims, in which the bandwidth of the filter device can be controlled in dependence on the output signal (OMPXA) of the circuit for suppressing the useful signal of the signal comprising the useful signal and the interference signal.

**9.** A demodulator circuit comprising a bandpass filter circuit and a circuit for suppressing a useful signal of a signal comprising a useful signal and an interference signal as claimed in any one of claims 1 to 6, arranged parallel to the bandpass filter circuit.

10. A demodulator circuit as claimed in claim 9, **characterized in that** the center frequency of the bandpass filter circuit can be controlled in dependence on the demodulated useful signal (OMPX).

11. A demodulator circuit as claimed in claim 9 or 10, comprising:

a bandpass filter (60), a first and a second mixer circuit (64, 70) and an adder circuit (66), wherein the bandpass filter (60) receives the input signal and generates a bandpass-filtered input signal, and the adder circuit (66) generates a notch filter output signal (ONOTCH) as a difference between the bandpass-filtered input signal and the input signal, the first mixer circuit (64) combines the bandpass-filtered input signal and a 90° phase-shifted input signal so as to generate a demodulated useful signal (OMPX), and the second mixer circuit (70) combines the notch filter output signal (ONOTCH) and a 90° phase-shifted input signal so as to generate a demodulated interference signal (OMPXA).

12. A demodulator circuit as claimed in claim 11, **characterized in that** the bandpass filter (72) receives the input signal and the 90° phase-shifted input signal, and the bandpass filter (72) precedes two parallel circuit branches each comprising an adder circuit (90, 92) so as to generate a first and a second, 90° phase-shifted notch filter output signal (ONOTCH COS, ONOTCH SIN), as well as two parallel demodulator branches each comprising a mixer circuit (74, 78) so as to generate a first and a second, 90° phase-shifted demodulated useful signal.

13. A demodulator circuit as claimed in claim 12, **characterized in that** the two demodulator branches are connected in one adder circuit (80) so as to generate a difference between the demodulated useful signal and the phase-shifted demodulated useful signal, the adder circuit (80) preceding an amplifier circuit (84).

14. A demodulator circuit as claimed in claim 12 or 13, **characterized in that** the outputs of the two circuit branches for suppressing the useful signal are connected to an adder circuit (102) so as to form a difference between the demodulated interference signal and the phase-shifted demodulated interference signal.

**Revendications**

1. Circuit pour la suppression d'un signal utile d'un signal comprenant un signal utile et un signal brouilleur avec un filtre d'encoches (30), qui reçoit un signal d'entrée (INCOS), lequel comprend le signal utile et le signal brouilleur, et qui produit un signal filtré, le filtre d'encoches (30) présentant une fréquence centrale, qui correspond environ à la fréquence du signal utile, pour supprimer au moins une partie du signal utile, et un circuit de commutation mélangeur (36 ; 38), qui reçoit le signal filtré et qui émet un signal de sortie démodulé (OMPXA), qui correspond sensiblement au signal brouilleur,
**caractérisé en ce que**
le circuit de commutation mélangeur reçoit en outre un signal d'entrée déphasé (INSIN) et **en ce que** un réseau déphaseur (32) est monté en série avec le filtre d'encoches (30).

2. Circuit selon la revendication 1, **caractérisé par** un déphaseur à 90° monté en amont du circuit de commutation mélangeur (36 ; 38) pour la production d'un signal d'entrée déphasé à 90° (INSIN) pour le circuit de commutation mélangeur (36 ; 38).

3. Circuit selon l'une quelconque des revendications précédentes, **caractérisé en ce que** le filtre d'encoches (30) reçoit le signal d'entrée (INCOS) et un signal d'entrée déphasé à 90° (INSIN) et produit deux signaux de sortie du filtre d'encoches déphasés à 90° (OCOS, OSIN),
**en ce que** le filtre d'encoches (30) est monté en aval du réseau déphaseur (40, 42), lequel reçoit les signaux de sortie du filtre d'encoches (OCOS, OSIN), et grâce à deux branches de démodulateur, qui présentent respectivement un circuit de commutation mélangeur (44, 46), une première entrée d'un premier circuit de commutation mélangeur (44) recevant le signal d'entrée et une seconde entrée du premier circuit de commutation mélangeur (44) recevant un signal de sortie du réseau déphaseur, qui repose sur un signal d'entrée déphasé à 90°, une première entrée du second circuit de commutation mélangeur (46) recevant le signal d'entrée déphasé à 90° et une seconde entrée du second circuit de commutation mélangeur (46) recevant un signal de sortie du réseau déphaseur, qui repose sur un signal d'entrée non déphasé, et les signaux de sortie des circuits de commutation mélangeurs (44, 46) étant combinés dans un circuit sommateur (48) afin de produire un signal brouilleur démodulé (OMPXA).

4. Circuit selon la revendication 3, **caractérisé en ce que** la fréquence centrale du filtre d'encoches (30) peut être commandée en fonction du signal utile.

5. Circuit selon l'une quelconque des revendications précédentes, **caractérisé en ce que** le filtre d'encoches est réalisé à l'aide d'un filtre passe-bande (52) selon la formule « 1-A(BP) = A(Notch) », A(BP) étant la fonction de transfert du filtre passe-bande (52) et A(Notch) la fonction de transfert du filtre d'encoches.

6. Circuit selon la revendication 5, **caractérisé en ce que** le filtre d'encoches présente un circuit de filtre passe-bande (52 ; 60) et un circuit de commutation sommateur (56 ; 66), **en ce que** le circuit de filtre passe-bande (52 ; 60) reçoit le signal d'entrée et produit un signal d'entrée filtré par le filtre passe-bande et le circuit de commutation sommateur (56 ; 66) produit un signal de sortie du filtre d'encoches (ONOTCH) comme une différence du signal d'entrée filtré par le filtre passe-bande et du signal d'entrée.

7. Circuit selon l'une quelconque des revendications précédentes, **caractérisé en ce qu'**un étage de mise en forme d'impulsion (54 ; 62) est monté en série avec le filtre d'encoches.

8. Dispositif de filtrage pour la suppression de signaux brouilleurs, **caractérisé par** un circuit pour la suppression d'un signal utile d'un signal comprenant un signal utile et un signal brouilleur selon l'une des revendications précédentes, la largeur de bande du dispositif de filtrage pouvant être commandée en fonction du signal de sortie (OMPXA) du circuit pour la suppression du signal utile du signal comprenant le signal utile et le signal brouilleur.

9. Circuit de démodulation avec un circuit de filtre passe-bande et un circuit pour la suppression d'un signal utile d'un signal comprenant un signal utile et un signal brouilleur selon l'une des revendications précédentes 1 à 6, qui est monté parallèlement au circuit de filtre passe-bande.

10. Circuit de démodulation selon la revendication 9, **caractérisé en ce que** la fréquence centrale du circuit de filtre passe-bande peut être commandée en fonction du signal utile démodulé (OMPX).

11. Circuit de démodulation selon la revendication 9 ou 10, comprenant :

un filtre passe-bande (60), un premier et un second circuit de commutation mélangeur (64, 70) et un circuit de commutation sommateur (66), le filtre passe-bande (60) recevant le signal d'entrée et produisant un signal d'entrée filtré par le filtre passe-bande et le circuit de commutation sommateur (66) produisant un signal de sortie de filtre d'encoches (ONOTCH) comme une différence du signal d'entrée filtré par le filtre passe-bande et du signal d'entrée, le premier circuit de commutation mélangeur (64) combinant le signal d'entrée filtré par le filtre passe-bande et un signal d'entrée déphasé à 90°, afin de produire un signal utile démodulé (OMPX), et le second circuit de commutation mélangeur (70) combinant le signal de sortie du filtre d'encoches (ONOTCH) et un signal d'entrée déphasé à 90° afin de produire un signal brouilleur démodulé (OMPXA).

12. Circuit de démodulation selon la revendication 11, **caractérisé en ce que** le filtre passe-bande (72) reçoit le signal d'entrée et le signal d'entrée déphasé à 90° et que deux branches de circuit parallèles sont montées en aval du filtre passe-bande (72) pour la suppression du signal utile, lesquelles présentent respectivement un circuit de commutation sommateur (90, 92), afin de produire un premier et un second signal de sortie du filtre d'encoches déphasé à 90° (ONOTCH COS, ONOTCH SIN), ainsi que deux branches de démodulateur parallèles, lesquelles présentent respectivement un circuit de commutation mélangeur (74, 78), afin de produire un premier et un second signal utile démodulé déphasé à 90°.

13. Circuit de démodulation selon la revendication 12, **caractérisé en ce que** les deux branches de démodulateur sont conduites dans un circuit de commutation sommateur (80) afin de produire une différence à partir du signal utile démodulé et du signal utile démodulé déphasé, un circuit de commutation en d'amplification (84) étant monté en aval du circuit de commutation sommateur (80).

14. Circuit de démodulation selon la revendication 12 ou 13, **caractérisé en ce que** les sorties des deux branches du circuit pour la suppression du signal utile sont conduites sur un circuit de commutation sommateur (102) afin de constituer une différence entre le signal brouilleur démodulé et le signal brouilleur démodulé déphasé.

FIG. 1

FIG. 2

FIG. 3

FIG. 4

FIG. 5

FIG. 6

FIG. 7

FIG. 8

FIG. 9

EP 1 257 051 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5307517 A
- JP 0590040308A A
- JP 0060069821A A
- JP 0030004630A A
- DE 3840999 A
- DE 19735798 A
- DE 4220228 A
- US 5220686 A
- US 5341107 A